# EUROPÄISCHE PATENTSCHRIFT

(11) **EP 1 761 941 B1**
(45) Veröffentlichungstag und Bekanntmachung des Hinweises auf die Patenterteilung: **28.05.2008**
(21) Anmeldenummer: 05751007.5
(22) Anmeldetag: 08.06.2005
(51) Int. Cl.: H01J 7/00, H01J 25/00

(54) **MIKROWELLENGENERATOR**
MICROWAVE GENERATOR
GENERATEUR DE MICRO-ONDES

(30) Priorität: 29.06.2004 DE 102004031333
(43) Veröffentlichungstag der Anmeldung: 14.03.2007
(73) Patentinhaber: Diehl BGT Defence GmbH & Co.KG, 88662 Überlingen (DE)
(72) Erfinder: STAINES, Geoffrey, San Diego 92111 (US); DOMMER, Josef, 90451 Nürnberg (DE)
(74) Vertreter: Braun, Werner
(86) Internationale Anmeldenummer: PCT/EP2005/006127
(87) Internationale Veröffentlichungsnummer: WO 2006/000296

(56) Entgegenhaltungen:
- US-A1- 2003 076 044
- US-A1- 2004 066 117
- US-A1- 2004 190 214
- US-A1- 2004 217 711

## Beschreibung

Die Erfindung betrifft einen Mikrowellengenerator, umfassend ein Gehäuse mit zwei einander gegenüberliegenden, über einen mit einem Dielektrikum gefüllten Elektrodenzwischenraum getrennten Elektroden mit dazwischenliegender, bei Anliegen einer Hochspannung zur Abstrahlung von Mikrowellen durchschlagender Funkenstrecke.

Die Funktion eines solchen Mikrowellengenerators beruht darauf, dass ein Hochspannungsspeicher, beispielsweise eine Kondensatorstruktur, die über eine Hochspannungsversorgung, z.B. in Form eines Marx'schen Generators aufgeladen wird, über eine Funkenstrecke kurzgeschlossen und damit entladen wird. Infolge des Kurzschlusses entstehen stark oszillierende Entlade- oder Kurzschlussströme mit einer steilen Flanke, die eine Mischung sehr hoher Frequenzen enthalten, die in der Regel über eine Antenne als Mikrowellenenergie mit einem breitbandigen, vom Frequenzgemisch abhängigen Spektrum abgestrahlt werden. Dieses breitbandige Mikrowellenspektrum weist eine so hohe Energiedichte auf, dass in der Umgebung eines solchen Mikrowellengenerators der Funkverkehr zumindest beeinträchtigt und Eingangskreise elektronischer Schaltungen aufgrund von Resonanzeffekten gestört oder sogar zerstört werden können.

Die Abstrahlung der Mikrowellen beruht auf einem entladungsbedingten Resonanzeffekt. Den Zündelektroden, zwischen denen die Funkenstrecke ausgebildet ist, sind weitere resonierende Elektroden- oder Leiterstrukturen zugeordnet, in denen der beim Durchschlagen erzeugte Entladestromimpuls zu kräftigen Sprungoszillationen führt, deren Frequenzgemisch eine Resonanzüberhöhung nach Maßgabe der momentanen elektrisch wirksamen Geometrie des Resonators bzw. der Resonatorstruktur ist.

Bei einer bekannten Ausführungsform eines Mikrowellengenerators der eingangs genannten Art sind die beiden koaxial angeordneten Zündelektroden der Funkenstrecke mit kugelkappenförmigen, großflächigen Elektroden, die die Antenne bilden und die mit ihrer Wölbung gegeneinander gerichtet sind, verbunden. Die beiden flächigen Elektroden oder Antennenelektroden schließen zwischen sich einen Zwischenraum, der seitlich vom Generatorgehäuse begrenzt ist, ein, in welchem Zwischenraum ein Dielektrikum, in der Regel ein gasförmiges oder flüssiges Dielektrikum, vorgesehen ist. Dieses Dielektrikum bestimmt die Kapazität und damit die Resonanzfrequenz der Antennenelektrodenstruktur und mit dieser die abgestrahlte Frequenz bzw. das Frequenzspektrum der Hochleistungs-Mikrowellen. Dieses Frequenzspektrum ist aufgrund der kapazitiv invarianten Auslegung der Resonatorstruktur bestehend aus den Antennenelektroden unveränderbar.

Das Dokument US 2003/076044 wird als nächstliegender Stand der Technik angesehen und offenbart ein Mikrowellengenerator, umfassend ein Gehäuse mit zwei einander gegenüberliegenden, über einen mit einem Dielektrikum gefüllten Elektrodenzwischenraum getrennten Elektroden.

Der Erfindung liegt das Problem zugrunde, einen Mikrowellengenerator anzugeben, bei dem die Möglichkeit zur Veränderung des Frequenzspektrums der abgestrahlten Mikrowellenpulse besteht.

Zur Lösung dieses Problems ist bei einem Mikrowellengenerator der eingangs genannten Art erfindungsgemäß vorgesehen, dass zur Veränderung der Mikrowellenfrequenz der Elektrodenzwischenraum mit einem zweiten Dielektrikum, das eine andere Dielektrizitätskonstante als das zwischen den Elektroden befindliche erste Dielektrikum besitzt, zumindest teilweise fühlbar ist, welches zweite Dielektrikum in einem mit dem Elektrodenzwischenraum kommunizierenden Reservoir bevorratet ist.

Bei dem erfindungsgemäßen Mikrowellengenerator ist die wirksame Kapazität zwischen den Elektroden, die den Antennenresonator bilden, durch gezieltes Verändern des kapazitätsbeeinflussenden Dielektrikums im Elektrodenzwischenraum veränderbar, mithin kann die Resonanzfrequenz und über diese schlussendlich die Mikrowellenfrequenz verändert und eingestellt werden, um sich im Bedarfsfall den Gegebenheiten des über die Mikrowellen zu störenden oder zu zerstörenden Objekts anzupassen. Hierzu ist generatorseitig ein Reservoir mit einem zweiten Dielektrikum vorgesehen, das eine andere Dielektrizitätskonstante als das ursprünglich im Elektrodenzwischenraum befindliche Dielektrikum besitzt. Beispielsweise befindet sich ursprünglich ein gasförmiges Dielektrikum, z.B. SF₆ im Elektrodenzwischenraum, als zweites Dielektrikum befindet sich Wasser im Reservoir. Dieses Wasser kann nun bei Bedarf aus dem Reservoir über eine zum Elektrodenzwischenraum führende Verbindungsleitung in diesen gefördert werden, so dass dieser mit dem Austausch-Dielektrikum teilweise oder vollständig befüllbar ist, wobei natürlich jedweder zwischen 0 und 100 % liegende Füllzustand unter mengenabhängiger Veränderung der Kapazität und damit des Abstrahlverhaltens eingestellt werden kann. Damit ermöglicht der erfindungsgemäße Mikrowellengenerator eine kontinuierliche Frequenzdurchmischung zwischen zwei Endzuständen, die über eine jeweils annähernd 100 %ige Befüllung mit dem einen oder dem anderen Dielektrikum definiert sind.

Neben dem Reservoir für das zweite Dielektrikum sieht eine Weiterbildung der Erfindung auch ein weiteres Reservoir für das erste Dielektrikum vor, so dass das erste und das zweite Dielektrikum reversibel in den Elektrodenzwischenraum förderbar sind, das heißt, es kann je nach Belieben das eine oder andere im Austausch in den Elektrodenzwischenraum gepumpt werden. Eine mehrfache Veränderung bei einer Mehrfachnutzung des Mikrowellengenerators ist damit ohne weiteres möglich.

Die Elektroden können letztlich von ihrer Form her beliebig sein, beispielsweise können sie als flache Scheiben oder hohlzylindrisch ausgeführt sein. Zweckmäßig sind sie aber kugelkappenartig ausgebildet und randseitig unter Begrenzung des Elektrodenzwischenraums am Gehäuse angeschlossen. Hierüber kann ein kompakter, jedoch ein für den Einsatzzweck dienliches Resonanzverhalten zeigender Resonator aufgebaut werden.

Eine besonders vorteilhafte Erfindungsausgestaltung sieht vor, eine den Elektrodenzwischenraum zum Gehäuse hin begrenzende flexible, dehnbare Membran zu verwenden, die sich bei Druckbeaufschlagung in den Elektrodenzwischenraum hineindehnt. Diese Membran, die bei einer koaxialen, rotationssymmetrischen Ausbildung des Resonators als ringförmige Manschette ausgeführt ist, stellt zum einen aufgrund ihrer Dehnbarkeit sicher, dass der Elektrodenzwischenraum annähemd vollständig mit dem zweiten Dielektrikum gefüllt werden kann, nachdem die Membran so flexibel ist, dass sie sich in alle Bereiche und Ecken des Elektrodenzwischenraums dehnen kann, sofern der sie verformende Druck hinreichend groß ist. Darüber hinaus wird hierüber sichergestellt, dass bei einem Abzug des zweiten Dielektrikums, beispielsweise Wasser, dieses auch vollständig aus dem Elektrodenzwischenraum gefördert wird, nachdem es die Elektroden selbst nicht benetzt und die Membran in ihre Ausgangslage in dichter Anlage an der Gehäusewand relaxiert.

Wenngleich unterschiedliche Konstruktionsmöglichkeiten hinsichtlich des Resonators, also hinsichtlich der Antennenelektroden bzw. deren Geometrie bestehen, sieht wie beschrieben eine vorteilhafte Ausgestaltung vor, die Membran ringförmig entlang der Gehäuseinnenwand anzuordnen, so dass sie sich bei Druckbeaufschlagung gleichförmig in den Elektrodenzwischenraum zur gekapselten, mittig angeordneten Funkenstrecke hin dehnt. Hierüber wird sichergestellt, dass bei einer Druckbeaufschlagung (Pressen oder Saugen), wenn also das zweite Dielektrikum zugeführt werden soll, die Membran symmetrisch um den Umfang von außen nach innen hineingedehnt wird, sich also eine an allen Orten gleichförmige Veränderung ergibt. Hierüber ist eine homogene Kapazitätsänderung über die gesamte Elektroden- oder Resonatorfläche gewährleistet, die in einer homogenen Änderung der Resonanz- und damit der Mikrowellenfrequenz resultiert.

Um das erste Dielektrikum, beispielsweise ein Isoliergas, aus dem Elektrodenzwischenraum abziehen zu können, ist es zweckmäßig, hierfür an einer Elektrode wenigstens eine Öffnung zum Abziehen und - sofern eine reversible Zufuhr vorgesehen ist - zum Zuführen des Isoliergases vorzusehen. Zweckmäßigerweise befindet sich diese Öffnung in einem Elektrodenbereich, der von der Membran konstruktiv bedingt wenn überhaupt dann erst zu allerletzt abgedeckt und mithin gegebenenfalls abgedichtet wird.

Um den Mikrowellengenerator möglichst kompakt zu konzipieren ist es vorteilhaft, das Reservoir für das zweite Dielektrikum unmittelbar hinter einer der Elektroden, von dieser begrenzt, vorzusehen. Das heißt, der koaxiale Aufbau des Generators setzt sich auch bei der Anordnung dieses Reservoirs fort. Für eine einfache Förderung bietet sich auch hier an, eine Membran vorzusehen, die das Reservoir begrenzt und bei Druckbeaufschlagung das Reservoir verkleinert und dabei das zweite Dielektrikum heraus- und in den Elektrodenzwischenraum hinein- bzw. gegen die dort befindliche Membran drückt. Die Membranen selbst sind zweckmäßigerweise aus einem dehnbaren, flexiblen Kunststoff, vornehmlich Gummi.

Hinsichtlich des Austauschs des Dielektrikums sind unterschiedliche Fördermöglichkeiten denkbar. Zum einen ist es möglich, dass zweite Dielektrikums durch Erzeugen eines Unterdrucks im Elektrodenzwischenraum durch Abziehen des ersten Dielektrikums mittels einer Pumpeinrichtung in den Elektrodenzwischenraum zu fördern. Es wird also beispielsweise das darin befindliche Isoliergas abgesaugt, wodurch die Membran durch den herrschenden Unterdruck in den Elektrodenzwischenraum gezogen wird, und mit ihr das im Reservoir befindliche zweite Dielektrikum, unterstützt gegebenenfalls von der bei vollem Reservoir gespannten, nun relaxierenden weiteren Membran. Alternativ ist es auch denkbar, die weitere Membran mit einem Pumpendruck von außen gesehen zu beaufschlagen und so das zweite Dielektrikum gegen die erste Membran und damit in den Elektrodenzwischenraum zu pressen, wodurch das darin befindliche erste Dielektrikum aus dem Elektrodenzwischenraum herausgepresst wird, gegebenenfalls gesteuert über ein Ventil oder dergleichen. Natürlich ist es auch denkbar, beide Vorgänge simultan anzusteuern, das heißt, über die Pumpeneinrichtung wird zum einen abgesaugt, zum anderen das Reservoir aktiv verkleinert. Dabei ist es denkbar, zur Druckbeaufschlagung der weiteren Membran des Reservoirs das über die Pumpeneinrichtung umgepumpte erste Dielektrikum, das gegebenenfalls ebenfalls mit einem Reservoir in Verbindung steht, zu verwenden.

Wie beschrieben lässt der erfindungsgemäße Mikrowellengenerator die Veränderung der Kapazität und daraus folgend der Resonanz- und Abstrahlfrequenz zu, resultierend aus einem Austausch des Dielektrikums. Dabei ist es möglich, dass zweite Dielektrikum während der laufenden Mikrowellenerzeugung in den Elektrodenzwischenraum zu fördern, das heißt, es besteht die Möglichkeit, während des Mikrowellenerzeugungsbetriebs aktiv die Frequenz durchzustimmen. Von Mikrowellenpuls zu Mikrowellenpuls ändert sich also das breitbandige Frequenzspektrum. Dabei besteht die Möglichkeit, die Zufuhr des zweiten Dielektrikums in Abhängigkeit eines Vergleichs der während der Mikrowellenerzeugung kontinuierlich gemessenen Ist-Frequenz der Mikrowellen mit einer Soll-Frequenz (oder entsprechender Frequenzspektren) zu steuern. Ist beispielsweise im Hinblick auf das zu störende Objekt ein bestimmtes Frequenzspektrum erforderlich, so kann der Generator so gesteuert werden, dass - ausgehend vom Grundzustand - die Mikrowellenerzeugung initiiert wird, gleichzeitig aber auch der Dielektrikumsaustausch erfolgt, und zwar solange, bis das gewünschte Soll-Spektrum eingestellt ist.

Weitere Vorteile, Merkmale und Einzelheiten der Erfindung ergeben sich aus den im folgenden beschriebenen Ausführungsbeispielen sowie anhand der Zeichnungen. Dabei zeigen:
- Fig. 1: eine Prinzipdarstellung eines erfindungsgemäßen Mikrowellengenerators einer ersten Ausführungsform im Schnitt,
- Fig. 2: den Mikrowellengenerator aus Fig. 1 nach einem Austausch des Dielektrikums,
- Fig. 3: eine Prinzipdarstellung eines erfindungsgemäßen Mikrowellengenerators einer zweiten Ausführungsform, und
- Fig. 4: eine Prinzipdarstellung eines erfindungsgemäßen Mikrowellengenerators einer dritten Ausführungsform.

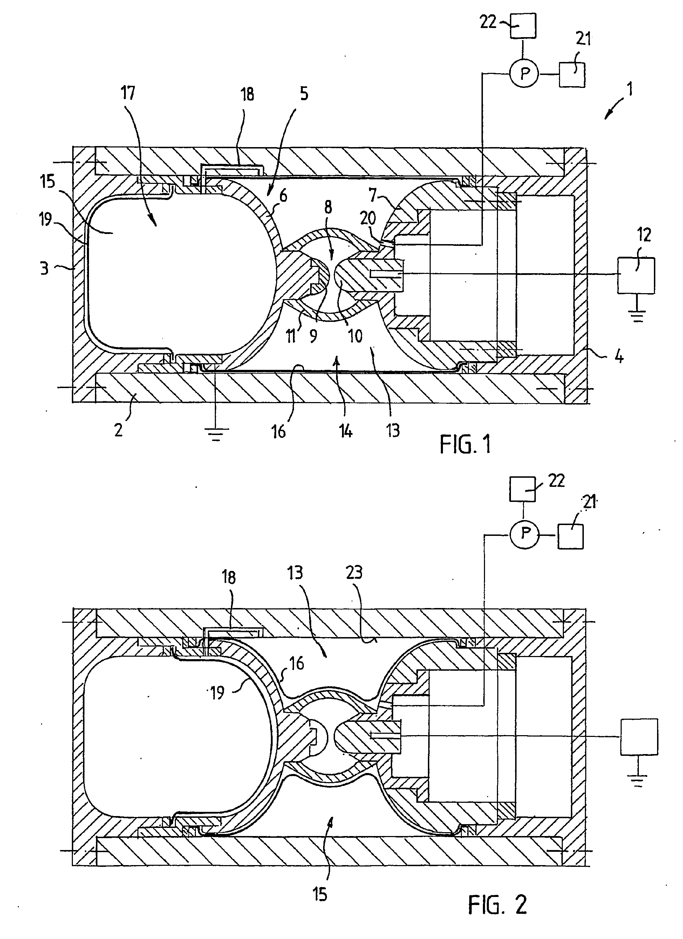

Fig. 1 zeigt einen erfindungsgemäßen Mikrowellengenerator 1 in Form einer Prinzipdarstellung. Er besteht aus einem Isoliergehäuse 2, das beidseitig über Abschlussdeckel 3, 4 abgeschlossen ist. Im Inneren ist ein Resonator 5 ausgebildet, bestehend aus zwei einander gegenüberliegend angeordneten Elektroden 6, 7, die im gezeigten Ausführungsbeispiel kugelkappenförmig ausgebildet sind. Mittig ist eine Funkenstrecke 8 vorgesehen, umfassend zwei voneinander beabstandete Zündelektroden 9, 10, die in einem Gehäuse 11 gekapselt aufgenommen sind, welches Gehäuse 11 mit einem gasförmigen oder flüssigen Dielektrikum gefüllt ist. Zum Erzeugen von Mikrowellen erzeugt ein Hochspannungsgenerator 12, beispielsweise ein Generator, der gemäß dem Prinzip der Marx'schen Stoßspannungsschaltung arbeitet, eine Spannung, die im gezeigten Beispiel an die Elektrode 7 gelegt wird. Die beiden Elektroden 6, 7 bilden eine Kondensatorstruktur, die über die Hochspannungsquelle 12 aufgeladen werden kann. Erreicht die Ladespannung an der Elektrode 7 die Durchschlagsspannung der Funkenstrecke 8, so kommt es zur Lichtbogenzündung, also zum Kurzschluss zwischen den beiden Elektroden 6, 7, wodurch hochfrequente Entladeströme in den Elektroden 6, 7 oszillieren, so dass es zu einem Resonanzverhalten kommt, und mithin zur Abstrahlung von hochenergetischen Mikrowellen über die beiden Elektroden 6, 7, die als Antennenelektroden fungieren. Die Kapazität der Kondensatoranordnung, bestehend aus den beiden Elektroden 6, 7, wird im Wesentlichen durch das im Elektrodenzwischenraum 13 befindliche Dielektrikum 14 bestimmt. Im gezeigten Ausführungsbeispiel sei angenommen, dass das erste Dielektrikum 14 ein gasförmiges Dielektrikum, z.B. SF₆ ist.

Um nun die Möglichkeit einer Änderung des Resonanzverhaltens und mithin der Frequenz der abgestrahlten Mikrowellen zu geben, ist es beim erfindungsgemäßen Mirkowellengenerator 1 möglich, das erste Dielektrikum 14 gegen ein zweites Dielektrikum 15 mit einer anderen Dielektrizitätskonstante auszutauschen. Das zweite Dielektrikum sei beispielsweise Wasser mit einer hohen Dielektrizitätskonstante von εᵣ=80. Wasser besitzt im gepulsten Betrieb eine sehr hohe Spannungsfestigkeit. Wird Wasser im Elektrodenzwischenraum 13 angeordnet, so ändert sich die Kapazität, bei einer vollständigen Befüllung ergibt sich eine maximale Kapazität und damit die minimale Resonanzfrequenz der Antennenstruktur, bestehend aus den Elektroden 6, 7 im Vergleich zur minimalen Kapazität bei vollständiger Gasbefüllung des Elektrodenzwischenraums 13, einhergehend mit der höchsten Resonanzfrequenz, wobei die Dielektrizitäskonstante von Gasen bei εᵣ≈1 liegt.

Um den Elektrodenzwischenraum 13 mit einem anderen, nämlich dem zweiten Dielektrikum 15 zu befüllen, ist der Elektrodenzwischenraum außenseitig mit einer flexiblen Membran 16, vorzugsweise einer ring- oder manschettenförmigen Gummimembran, die die koaxiale Elektrodenanordnung zum Gehäuse 2 hin abschließt, ausgekleidet. Aus dem Reservoir 17, in dem das zweiten Dielektrikum bevorratet ist, führt eine Verbindungsleitung 18 durch das Antennengehäuse 2 hinter die Membran 16. Das Reservoir 17 selbst ist einseitig über die Elektrode 6, anderseitig über eine weitere flexible Membran 19 dicht abgeschlossen.

Zum Abziehen oder Zuführen des im Elektrodenzwischenraums 13 befindlichen ersten Dielektrikums ist eine Öffnung 20 im Bereich der Elektrode 7 vorgesehen, an der im gezeigten Ausführungsbeispiel eine Pumpeinrichtung P angeschlossen ist, deren Betrieb über eine Steuerungseinrichtung 21 gesteuert wird, und die z.B. mit einem Reservoir 22 für das erste Dielektrikum 14 in Verbindung steht.

Soll nun ein Austausch des Dielektrikums erfolgen, wird über die Pumpeneinrichtung P (dies kann eine beliebige Pumpe sein) das erste Dielektrikum 14 abgesaugt und in das Reservoir 22 gefördert. Hierüber entsteht im Elektrodenzwischenraum ein Unterdruck, der die flexible Membran 16 nach innen saugt. Dies erfolgt gleichmäßig um den Umfang des Elektrodenzwischenraums 13, nachdem der Aufbau rotationssymmetrisch ist. Gleichzeitig bildet sich aufgrund der nach innen gezogenen Membran 16 zum Reservoir 17 hin ein Unterdruck, der dazu führt, dass das zweite Dielektrikum 15 über die Verbindungsleitung 18 nachgesaugt wird und sich umfänglich homogen in dem Zwischenraum zwischen der Membran 16 und der Innenfläche 23 des Gehäuses 2 verteilt. Während Fig. 1 den Zustand zeigt, in dem der Elektrodenraum 13 zwischen den Elektroden 6, 7, die einen Dipol bilden, vollständig mit dem ersten Dielektrikum 14 gefüllt ist, zeigt Fig. 2 die Situation, in dem das erste Dielektrikum 14 annähernd vollständig abgepumpt und der Elektrodenzwischenraum 13 mit dem zweiten Dielektrikum 15 annähernd vollständig (soweit eine Auskleidung im Bereich zur Kapselung durch das Gehäuse 11 über die Membran 16 möglich ist) gefüllt ist. Ersichtlich ist die weitere Membran 19 in Anlage an die Elektrode 6 gezogen. Dabei entspricht das Volumen des Reservoirs 17 im Wesentlichen dem Volumen des Elektrodenzwischenraums 13.

Soll nun der Ausgangszustand wieder hergestellt werden, würde über die Pumpeneinrichtung P das erste Dielektrikum 14 aus dem Reservoir 22 wieder in den Elektrodenzwischenraum unter die Membran 16 gepresst werden, was dazu führt, dass diese in ihre Ausgangslage zurückgedrängt und das zweite Dielektrikum 15 über die Verbindungsleitung 18 (von denen natürlich um den Umfang verteilt mehrere vorgesehen sein können) in das Reservoir 17 zurückgefördert wird, bis sich der in Fig. 1 gezeigte Zustand wieder einstellt. Dabei ist es grundsätzlich möglich, jedweden zwischen den in den Figuren 1 und 2 gezeigten Endzuständen liegenden Zwischenfüllzustand einzustellen.

Infolge der Änderung des im Elektrodenzwischenraums befindlichen Dielektrikums stellt sich je nach Befüllgrad mit dem einen oder anderen Dielektrikum stets eine unterschiedlich resultierende "Gesamtdielektrizitätskonstante" ein, die bestimmend für die Kapazität der Resonatorstruktur 5 ist. Hierüber kann also wie beschrieben das Resonanzverhalten und mithin das Frequenzspektrum der abgestrahlten Hochleistungs-Mikrowellenpulse eingestellt bzw. durchgestimmt werden.

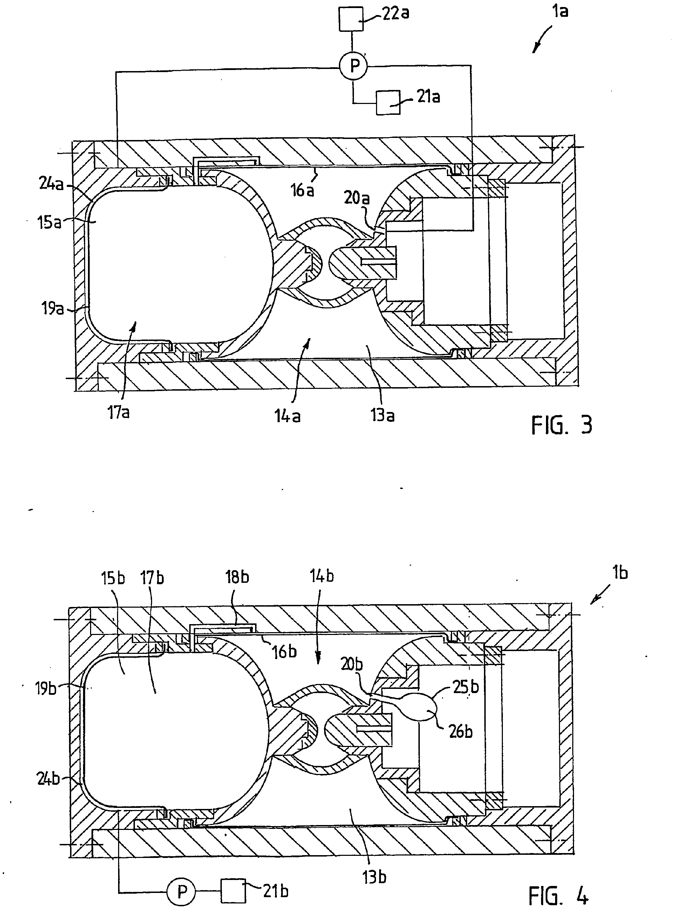

Fig. 3 zeigt eine weitere Ausführungsform eines erfindungsgemäßen Mikrowellengenerators 1a, dessen Aufbau dem Mikrowellengenerator 1 aus den Figuren 1 und 2 entspricht. Jedoch ist hier die Pumpeneinrichtung P nicht nur mit der Öffnung 20a zum Absaugen des im Elektrodenzwischenraums 13a befindlichen ersten Dielektrikum 14a verbunden, sondern auch über eine Zufuhrleitung mit dem Gehäusebereich 24a, der hinter der Membran 19a des Reservoirs 17a liegt. Wird die Pumpe zum Absaugen des ersten Dielektrikums 14a betrieben, so wird gleichzeitig beispielsweise aus dem Reservoir 22 entsprechendes erstes Dielektrikum 14a in den Gehäusebereich 24a gedrückt. Das heißt, es wird an der einen Seite aktiv unter Erzeugen eines Unterdrucks abgezogen, während auf der anderen Seite aktiv das zweite Dielektrikum 15a aus dem Reservoir 17a herausgedrückt wird.

Schließlich zeigt Fig. 4 eine dritte Ausführungsform eines erfindungsgemäßen Mikrowellengenerators 1b, dessen Aufbau dem des Mikrowellengenerators 1 aus Fig. 1 entspricht. Jedoch kommuniziert hier die Pumpeneinrichtung P ausschließlich mit dem hinter dem Reservoir 17b und damit hinter der weiteren flexiblen Membran 19b liegenden Gehäusebereichs 24b. Soll nun das im Elektrodenzwischenraum 13b befindliche erste Dielektrikum 14b ausgetauscht werden, wird über die Pumpe beispielsweise ein Gas in den Gehäuseraum 24b gepresst, so dass das zweite Dielektrikum 14b aus dem Reservoir 17b über die Verbindungsleitung 18b hinter die Membran 16b gedrückt wird, so dass diese sich in dem Elektrodenzwischenraum 13b wölbt. Auch hier ist, wie auch bei der Ausführungsform des Mikrowellengenerators 1a die Steuerungseinrichtung 21a, eine Steuerungseinrichtung 21b vorgesehen, die den Pumpenbetrieb steuert.

Das aus dem Elektrodenzwischenraum 13b herausgedrückte erste Dielektrikum 14b wird in einem beispielsweise ebenfalls über eine flexible Membran 25b gebildete Reservoir 26b aufgefangen. Die Membran 25b wird dabei ähnlich einem Ballon gedehnt. Soll wieder der in Fig. 4 gezeigte Zustand eingenommen werden, wird über die Pumpeneinrichtung P der Gehäuseraum 24b evakuiert, so dass die Membran 19b wieder nach außen gesaugt und mithin das zweite Dielektrikum 15b zurückgesaugt wird. Die Förderung des ersten Dielektrikums 14b in den Elektrodenzwischenraum 13b wird durch die Relaxation der gedehnten Membran 25b unterstützt.

An dieser Stelle ist darauf hinzuweisen, dass die jeweilige Steuerungseinrichtung 21, 21a oder 21b so ausgelegt sein kann, dass während des Betriebs des jeweiligen Mikrowellengenerators 1, 1a, 1b die Befüllung des jeweiligen Elektrodenzwischenraums erfolgt, mithin also während des Betriebs die Frequenzdurchstimmung erfolgt. Denkbar ist es auch, an der jeweiligen Steuerungseinrichtung eine Sollfrequenz oder ein Sollfrequenzspektrum auszuwählen, auf das hin die Regelung der Befüllung erfolgt, das heißt, es wird kontinuierlich das Ist-Frequenzspektrum gemessen und mit dem Soll-Frequenzspektrum verglichen und so lange die Dielektrizitätskonstante durch Befüllen des Elektrodenzwischenraums verändert, bis das Ist-Spektrum des Soll-Spektrum entspricht.

## Patentansprüche

1. Mikrowellengenerator, umfassend ein Gehäuse mit zwei einander gegenüberliegenden, über einen mit einem Dielektrikum gefüllten Elektrodenzwischenraum getrennten Elektroden mit dazwischenliegender, bei Anliegen einer Hochspannung zur Abstrahlung von Mikrowellen durchschlagender Funkenstrecke, **dadurch gekennzeichnet, dass** zur Veränderung der Mikrowellenfrequenz der Elektrodenzwischenraum (13, 13a, 13b) mit einem zweiten Dielektrikum (15, 15a, 15b), das eine andere Dielektrizitätskonstante als das zwischen den Elektroden (6, 7) befindliche erste Dielektrikum (14, 14a, 14b) besitzt, zumindest teilweise befüllbar ist, welches zweite Dielektrikum (15, 15a, 15b) in einem mit dem Elektrodenzwischenraum (13, 13a, 13b) kommunizierenden Reservoir (17, 17a, 17b) bevorratet ist.

2. Mikrowellengenerator nach Anspruch 1, **dadurch gekennzeichnet, dass** ein weiteres Reservoir (22, 22a, 25) für das erste Dielektrikum (14, 14a, 14b) vorgesehen ist, so dass das erste und das zweite Dielektrikum (14, 14a, 14b, 15, 15a, 15b) reversibel in den Elektrodenzwischenraum (13, 13a, 13b) förderbar sind.

3. Mikrowellengenerator nach Anspruch 1 oder 2, **dadurch gekennzeichnet, dass** die Elektroden (6, 7) kugelkappenartig sind und randseitig unter Begrenzung des Elektrodenzwischenraums (13, 13a, 13b) am Gehäuse (2) anschließen.

4. Mikrowellengenerator nach einem der vorangehenden Ansprüche, **dadurch gekennzeichnet, dass** eine den Elektrodenzwischenraum (13, 13a, 13b) zum Gehäuse (2) hin begrenzende, flexible dehnbare Membran (16, 16a, 16b) vorgesehen ist, die sich bei Druckbeaufschlagung in den Elektrodenzwischenraum (13, 13a, 13b) dehnt.

5. Mikrowellengenerator nach Anspruch 4, **dadurch gekennzeichnet, dass** die Membran (16, 16a, 16b) ringförmig entlang der Gehäuseinnenwand verläuft und bei Druckbeaufschlagung gleichförmig in den Elektrodenzwischenraum (13, 13a, 13b) zur gekapselten, mittig angeordneten Funkenstrecke (8) hin gedehnt wird.

6. Mikrowellengenerator nach einem der vorangehenden Ansprüche, **dadurch gekennzeichnet, dass** an einer Elektrode (7) wenigstens eine Öffnung (20, 20a, 20b) zum Abziehen und gegebenenfalls Zuführen des ersten Dielektrikums (14, 14a, 14b) vorgesehen ist.

7. Mikrowellengenerator nach einem der vorangehenden Ansprüche, **dadurch gekennzeichnet, dass** das Reservoir (17, 17a, 17b) für das zweite Dielektrikum (15, 15a, 15b) unmittelbar hinter einer der Elektroden (6), von dieser begrenzt, vorgesehen ist.

8. Mikrowellengenerator nach Anspruch 7, **dadurch gekennzeichnet, dass** eine weitere, das Reservoir (17, 17a, 17b) begrenzende, bewegbare und flexible Membran (19, 19a, 19b) vorgesehen ist.

9. Mikrowellengenerator nach einem der Ansprüche 4 bis 8, **dadurch gekennzeichnet, dass** die Menbranen (16, 16a, 16b, 19, 19a, 19b) aus Kunststoff, insbesondere Gummi sind.

10. Mikrowellengenerator nach einem der vorangehenden Ansprüche, **dadurch gekennzeichnet, dass** das zweite Dielektrikum (15, 15a) durch Erzeugen eines Unterdrucks im Elektrodenzwischenraum (13, 13a) durch Abziehen des ersten Dielektrikums (14, 14a) mittels einer Pumpeneinrichtung (P) in den Elektrodenzwischenraum (13, 13a) förderbar ist.

11. Mikrowellengenerator nach einem der Ansprüche 1 bis 9, **dadurch gekennzeichnet, dass** das zweite Dielektrikum (15b) durch Erzeugen eines auf das Reservoir (17b), insbesondere dessen flexible Membran (19b) wirkenden Drucks mittels derr Pumpeneinrichtung (P) in den Elektrodenzwischenraum (13b) förderbar ist.

12. Mikrowellengenerator nach Anspruch 10 oder 11, **dadurch gekennzeichnet, dass** die Pumpeneinrichtung (P) zum Absaugen und zur gleichzeitigen Druckbeaufschlagung der das Reservoir (17a) begrenzenden Membran (19a) dient.

13. Mikrowellengenerator nach Anspruch 12, **dadurch gekennzeichnet, dass** zur Druckbeaufschlagung das über die Pumpeneinrichtung (P) umgepumpte erste Dielektrikum (14a) dient.

14. Mikrowellengenerator nach einem der vorangehenden Ansprüche, **dadurch gekennzeichnet, dass** das zweite Dielektrikum (15, 15a, 15b) während der laufenden Mirkowellenerzeugung in den Elektrodenzwischenraum (13, 13a, 13b) förderbar ist.

15. Mikrowellengenerator nach Anspruch 14, **dadurch gekennzeichnet, dass** die Zufuhr des zweiten Dielektrikums (15, 15a, 15b) in Abhängigkeit eines Vergleichs der während der Mikrowellenerzeugung kontinuierlich gemessenen Ist-Frequenz mit einer Soll-Frequenz steuerbar ist.

## Claims

1. Microwave generator, comprising a housing having two mutually opposite electrodes which are separated via an electrode intermediate space which is filled with a dielectric, and with the electrodes having a spark gap between them, which breaks down in order to emit microwaves when a high voltage is applied, **characterized in that** the electrode intermediate space (13, 13a, 13b) can be at least partially filled with a second dielectric (15, 15a, 15b), which has a different dielectric constant to that of the first dielectric (14, 14a, 14b) which is located between the electrodes (6, 7) in order to vary the microwave frequency, which second dielectric (15, 15a, 15b) is held in a reservoir (17, 17a, 17b) which communicates with the electrode intermediate space (13, 13a, 13b).

2. Microwave generator according to Claim 1, **characterized in that** a further reservoir (22, 22a, 25) is provided for the first dielectric (14, 14a, 14b), so that the first and the second dielectrics (14, 14a, 14b, 15, 15a, 15b) can be fed reversibly into the electrode intermediate space (13, 13a, 13b).

3. Microwave generator according to Claim 1 or 2, **characterized in that** the electrodes (6, 7) are like spherical caps and are connected to the housing (2) at the edge, bounding the electrode intermediate space (13, 13a, 13b).

4. Microwave generator according to one of the preceding claims, **characterized in that** a flexible stretchable membrane (16, 16a, 16b), which bounds the electrode intermediate space (13, 13a, 13b) towards the housing (2), is provided and stretches into the electrode intermediate space (13, 13a, 13b) when pressure is applied.

5. Microwave generator according to Claim 4, **characterized in that** the membrane (16, 16a, 16b) runs in an annular shape along the housing inner wall and, when pressure is applied, is stretched uniformly into the electrode intermediate space (13, 13a, 13b) towards the encapsulated, centrally arranged spark gap (8).

6. Microwave generator according to one of the preceding claims, **characterized in that** at least one opening (20, 20a, 20b) is provided on one electrode (7) for extraction and if appropriate supply of the first dielectric (14, 14a, 14b).

7. Microwave generator according to one of the preceding claims, **characterized in that** the reservoir (17, 17a, 17b) for the second dielectric (15, 15a, 15b) is provided immediately behind one of the electrodes (6), bounded by it.

8. Microwave generator according to Claim 7, **characterized in that** a further movable and flexible membrane (19, 19a, 19b) is provided and bounds the reservoir (17, 17a, 17b).

9. Microwave generator according to one of Claims 4 to 8, **characterized in that** the membranes (16, 16a, 16b, 19, 19a, 19b) are composed of plastic, in particular rubber.

10. Microwave generator according to one of the preceding claims, **characterized in that** the second dielectric (15, 15a) can be fed into the electrode intermediate space (13, 13a) by production of reduced pressure in the electrode intermediate space (13, 13a), by extraction of the first dielectric (14, 14a) by means of a pump device (P).

11. Microwave generator according to one of Claims 1 to 9, **characterized in that** the second dielectric (15b) can be fed into the electrode intermediate space (13b) by production of a pressure, which acts on the reservoir (17b), in particular on its flexible membrane (19b), by means of the pump device (P).

12. Microwave generator according to Claim 10 or 11, **characterized in that** the pump device (P) is used for suction and for the application of pressure at the same time to the membrane (19a) which bounds the reservoir (17a).

13. Microwave generator according to Claim 12, **characterized in that** the first dielectric (14a), which is pumped around by the pump device (P), is used for application of pressure.

14. Microwave generator according to one of the preceding claims, **characterized in that** the second dielectric (15, 15a, 15b) can be fed into the electrode intermediate space (13, 13a, 13b) while microwaves are being produced.

15. Microwave generator according to Claim 14, **characterized in that** the supply of the second dielectric (15, 15a, 15b) can be controlled as a function of a comparison of a nominal frequency with the actual frequency which is measured continuously while microwaves are being produced.

## Revendications

1. Générateur d'hyperfréquences, comprenant un boîtier muni de deux électrodes opposées l'une à l'autre et séparées par un espace inter-électrodes rempli d'un diélectrique, entre lesquelles se trouve une section de décharge pénétrante lors de l'application d'une haute tension en vue de l'émission d'hyperfréquences, **caractérisé en ce que** pour modifier la fréquence des hyperfréquences, l'espace inter-électrodes (13, 13a, 13b) peut être rempli au moins partiellement d'un deuxième diélectrique (15, 15a, 15b) qui présente une constante diélectrique différente de celle du premier diélectrique (14, 14a, 14b) qui se trouve entre les électrodes (6, 7), lequel deuxième diélectrique (15, 15a, 15b) est tenu en réserve dans un réservoir (17, 17a, 17b) qui communique avec l'espace inter-électrodes (13, 13a, 13b).

2. Générateur d'hyperfréquences selon la revendication 1, **caractérisé en ce qu'**il est prévu un réservoir (22, 22a, 25) supplémentaire pour le premier diélectrique (14, 14a, 14b) de sorte que le premier et le deuxième diélectriques (14, 14a, 14b, 15, 15a, 15b) puissent être transportés de manière réversible dans l'espace inter-électrodes (13, 13a, 13b).

3. Générateur d'hyperfréquences selon la revendication 1 ou 2, **caractérisé en ce que** les électrodes (6, 7) sont de type à capuchon sphérique et se rattachent au boîtier (2) au niveau des côtés en délimitant l'espace inter-électrodes (13, 13a, 13b).

4. Générateur d'hyperfréquences selon l'une des revendications précédentes, **caractérisé en ce qu'**il est prévu une membrane (16, 16a, 16b) souple extensible qui délimite l'espace inter-électrodes (13, 13a, 13b) vers le boîtier (2) et qui s'étend dans l'espace inter-électrodes (13, 13a, 13b) lorsqu'elle est soumise à une pression.

5. Générateur d'hyperfréquences selon la revendication 4, **caractérisé en ce que** la membrane (16, 16a, 16b) s'étend sous forme annulaire le long de la paroi intérieure du boîtier et, lorsqu'elle est soumise à une pression, elle est étirée de manière homogène dans l'espace inter-électrodes (13, 13a, 13b) en direction de la section de décharge (8) encapsulée disposée au centre.

6. Générateur d'hyperfréquences selon l'une des revendications précédentes, **caractérisé en ce qu'**au moins une ouverture (20, 20a, 20b) est prévue sur une électrode (7) pour extraire et éventuellement acheminer le premier diélectrique (14, 14a, 14b).

7. Générateur d'hyperfréquences selon l'une des revendications précédentes, **caractérisé en ce que** le réservoir (17, 17a, 17b) pour le deuxième diélectrique (15, 15a, 15b) est prévu directement derrière l'une des électrodes (6) en étant délimité par celle-ci.

8. Générateur d'hyperfréquences selon la revendication 7, **caractérisé en ce qu'**il est prévu une membrane (19, 19a, 19b) supplémentaire mobile et souple qui délimite le réservoir (17, 17a, 17b).

9. Générateur d'hyperfréquences selon l'une des revendications 4 à 8, **caractérisé en ce que** les membranes (16, 16a, 16b, 19, 19a, 19b) sont en matière plastique, notamment en caoutchouc.

10. Générateur d'hyperfréquences selon l'une des revendications précédentes, **caractérisé en ce que** le deuxième diélectrique (15, 15a) peut être transporté dans l'espace inter-électrodes (13, 13a) en générant une dépression dans l'espace inter-électrodes (13, 13a) par extraction du premier diélectrique (14, 14a) au moyen d'un dispositif de pompage (P).

11. Générateur d'hyperfréquences selon l'une des revendications 1 à 9, **caractérisé en ce que** le deuxième diélectrique (15b) peut être transporté dans l'espace inter-électrodes (13b) en générant au moyen du dispositif de pompage (P) une pression qui agit sur le réservoir (17b), notamment sur sa membrane souple (19b).

12. Générateur d'hyperfréquences selon la revendication 10 ou 11, **caractérisé en ce que** le dispositif de pompage (P) sert à aspirer et simultanément à soumettre à une pression la membrane (19a) qui délimite le réservoir (17a).

13. Générateur d'hyperfréquences selon la revendication 12, **caractérisé en ce que** le premier diélectrique (14a) mis en circulation par pompage avec le dispositif de pompage (P) sert à appliquer la pression.

14. Générateur d'hyperfréquences selon l'une des revendications précédentes, **caractérisé en ce que** le deuxième diélectrique (15, 15a, 15b) peut être transporté dans l'espace inter-électrodes (13, 13a, 13b) pendant la génération des hyperfréquences en cours.

15. Générateur d'hyperfréquences selon la revendication 14, **caractérisé en ce que** l'acheminement du deuxième diélectrique (15, 15a, 15b) peut être commandé en fonction d'une comparaison de la fréquence réelle mesurée continuellement pendant la génération des hyperfréquences avec une fréquence de consigne.
